# EUROPEAN PATENT APPLICATION

(11) **EP 4 530 656 A1**
(43) Date of publication of application: **02.04.2025**
(21) Application number: 23199740.4
(22) Date of filing: 26.09.2023
(51) Int. Cl.: G01R 33/561, G01R 33/54, G01R 33/483

(54) **DETERMINING READOUT DIRECTIONS AND A PHASE ENCODING DIRECTIONS FOR PARALLEL MAGNETIC RESONANCE IMAGING**

(71) Applicant: Koninklijke Philips N.V., 5656 AG Eindhoven (NL)
(72) Inventor: NIELSEN, Tim, Eindhoven (NL); MEINEKE, Jan Jakob, Eindhoven (NL)
(74) Representative: Philips Intellectual Property & Standards

(57) **Abstract**

Disclosed herein is a method comprising: receiving (200) initial pulse sequence commands (122); receiving (202) calibration data (124); receiving (204) a volume of interest (126); receiving (206) a slice thickness (128) for at least one stack of slices; and receiving (208) a stack dependent stack orientation (130) for the at least one stack of slices. The method further comprises performing the following for slices: determining (210) a field of view (132) for a slice using the volume of interest, the slice thickness, and the stack orientation of the stack of slices; determining (212) a readout direction (136) for the slice and a phase encoding direction for the slice using the calibration data to optimize an image metric within the slice; and constructing (214) slice specific pulse sequence commands (140) by modifying the initial pulse sequence commands using the field of view, the readout direction, and the phase encoding direction.

## Description

### FIELD OF THE INVENTION

The invention relates to magnetic resonance imaging, in particular to parallel magnetic resonance imaging protocols.

### BACKGROUND OF THE INVENTION

A large static magnetic field is used by Magnetic Resonance Imaging (MRI) system or scanner to align the nuclear spins of atoms as part of the procedure for producing images within the body of a patient. This large static magnetic field is referred to as the B0 field or the main magnetic field. By controlling gradient magnetic fields and radio-frequency pulses the nuclear spins can be manipulated to produce radio-frequency signals that can be sampled or measured as k-space data. The k-space data can then be reconstructed into a magnetic resonance image which images internal anatomical structures of the subject. The time dependent control of the radio-frequency signals, time dependent magnetic field gradients, and radio-frequency pulses, as well as the sampling of the k-space data are described in so-called pulse sequences.

The acquisition of the k-space data to reconstruct a magnetic resonance image can take enough time that it is uncomfortable for the subject or the subject moves during the examination. It is therefore beneficial to accelerate the magnetic resonance imaging examination as quickly as possible. One means of accelerating the acquisition is through the use of parallel imaging techniques. In parallel imaging techniques, the k-space data is acquired using multiple antenna elements or coils that acquire radio signals from a spatially dependent region. Before acquiring the k-space data to acquire a clinical magnetic resonance image, a calibration procedure is performed where a set of coil sensitivity maps are measured and used to determine how much the k-space data measured by a particular coil contributes to the overall magnetic resonance image during the final reconstruction.

Mooiweer et. al, "Combining a Reduced Field of Excitation With SENSE-Based Parallel Imaging for Maximum Imaging Efficiency," Magnetic Resonance in Medicine 78:88-96 (2017) discloses generating G-factor maps to predict the performance of the SENSE and rSENSE accelerated scans.

### SUMMARY OF THE INVENTION

The invention provides for a medical system, a computer program, and a method in the independent claims. Embodiments are given in the dependent claims.

In one aspect the invention provides for a medical system that comprises a memory storing machine-executable instructions. The medical system further comprises a computational system. Execution of the machine-executable instructions causes the computational system to receive initial pulse sequence commands configured for controlling a magnetic resonance imaging system to acquire k-space data according to a parallel imaging magnetic resonance imaging protocol. Execution of the machine-executable instructions further causes the computational system to receive calibration data. Execution of the machine-executable instructions further causes the computational system to receive a volume of interest. Execution of the machine-executable instructions further causes the computational system to receive a slice thickness for at least one stack of slices positioned within the volume of interest. Execution of the machine-executable instructions further causes the computational system to receive a stack-dependent stack orientation for the at least one stack of slices.

Execution of the machine-executable instructions causes the computational system to perform the following for slices of the at least one stack of slices. This includes determining a field of view for the slice using the volume of interest, the slice thickness, and the stack-dependent stack orientation. This further includes determining a readout direction for the slice and a phase encoding direction for the slice using the calibration data to optimize an image metric within the slice. This further includes constructing slice-specific pulse sequence commands by modifying the initial pulse sequence commands using the field of view, the readout direction, and the phase encoding direction.

In another aspect the invention provides for a computer program that comprises machine-executable instructions for execution by a computational system. Execution of the machine-executable instructions causes the computational system to receive initial pulse sequence commands configured for controlling a magnetic resonance imaging system to acquire k-space data according to a parallel imaging magnetic resonance imaging protocol. Execution of the machine-executable instructions further causes the computational system to receive calibration data. Execution of the machine-executable instructions further causes the computational system to receive a volume of interest. Execution of the machine-executable instructions further causes the computational system to receive a slice thickness for at least one stack of slices positioned within the volume of interest. Execution of the machine-executable instructions further causes the computational system to receive a stack-dependent stack orientation for the at least one stack of slices.

The method further comprises performing the following steps for slices of the at least one stack of slices. This includes determining a field of view for the slice using the volume of interest, the slice thickness, and the stack-dependent orientation. This further includes determining a readout direction for the slice and a phase encoding direction for the slice using the calibration data to optimize an image metric within the slice. This further includes constructing slice-specific pulse sequence commands by modifying the initial pulse sequence commands using the field of view, the readout direction, and the phase encoding direction.

In another aspect the invention provides for a method of magnetic resonance imaging. The method comprises receiving initial pulse sequence commands that are configured for controlling the magnetic resonance imaging system to acquire k-space data according to a parallel imaging magnetic resonance imaging protocol. The method further comprises receiving calibration data. The method further comprises receiving a volume of interest. The method further comprises receiving a slice thickens for at least one stack of slices that are positioned within the volume of interest. The method further comprises receiving a stack-dependent stack orientation for the at least one stack of slices.

Execution of the machine-executable instructions further causes the computational system to perform the following for a slice of the at least one stack of slices. This includes determining a field of view for the slice using the volume of interest, the slice thickness, and the stack orientation of the stack of slices. This further comprises determining a readout direction for the slice and a phase encoding direction for the slice using the calibration data to optimize the image metric within the slice. This further comprises constructing slice-specific pulse sequence commands by modifying the initial pulse sequence commands using the field of view, the readout direction, and the phase encoding direction.

### BRIEF DESCRIPTION OF THE DRAWINGS

In the following preferred embodiments of the invention will be described, by way of example only, and with reference to the drawings in which:
Fig. 1 illustrates an example of a medical system.
Fig. 2 shows a flow chart which illustrates a method of using the medical system of Fig. 1.
Fig. 3 illustrates a further example of a medical system.
Fig. 4 shows a flow chart which illustrates a method of using the medical system of Fig. 3.
Fig. 5 illustrates a neural network architecture.
Fig. 6 illustrates a convolutional input stage for a neural network.
Fig. 7 illustrates a further example of an input state for a neural network.
Fig. 8 illustrates a further example of an input state for a neural network modeled after a U-net neural network.
Fig. 9 illustrates a further example of an input state for a neural network modeled after an F-net neural network.

### DETAILED DESCRIPTION OF EMBODIMENTS

Like numbered elements in these figures are either equivalent elements or perform the same function. Elements which have been discussed previously will not necessarily be discussed in later figures if the function is equivalent.

In examples the medical system may comprise a memory that stores machine-executable instructions. In examples the medical system further comprises a computational system. Execution of the machine-executable instructions causes the computational system to receive initial pulse sequence commands configured for controlling the magnetic resonance imaging system to acquire k-space data according to a parallel imaging magnetic resonance imaging protocol. The initial pulse sequence commands may for example be a template or example pulse sequence commands which are in general used to configure a magnetic resonance imaging system to acquire k-space data for a particular parallel imaging magnetic resonance imaging protocol. The initial pulse sequence commands may for example be intended to be modified for a particular acquisition.

Execution of the machine-executable instructions further causes the computational system to receive calibration data. The calibration data may for example be received by acquiring measurements with a particular magnetic resonance imaging system for an acquisition on a particular subject. In other examples, the calibration data may be cached or stored in a memory. In some examples the calibration data may also be data which is averaged.

The calibration data may for example take different forms. In some examples it may be a survey image. In other examples the calibration data may be a collection of images which are used to provide coil sensitivity maps for the parallel imaging protocol. In other examples, the calibration data may be previously acquired data from the subject or from different subjects or it may even be data which is averaged over many subjects.

Execution of the machine-executable instructions further causes the computational system to receive a volume of interest. In the case where the calibration data is images or comprises images, the location of the volume of interest may be indicated or referenced to the calibration data.

In examples, execution of the machine-executable instructions may cause the computational system to receive a slice thickness for the at least one stack of slices positioned within the volume of interest. Typically, when magnetic resonance images are acquired they may be acquired as a three-dimensional dataset or as a stack of two-dimensional slices. In this case, the k-space data is acquired for individual slices so that a three-dimensional dataset is acquired as a stack of slices. When performing such a three-dimensional imaging procedure, it is possible that more than one stack of slices is acquired. Very often, the resolution of the image in the thickness and within the plane of a particular stack is different. By acquiring multiple stacks an isotropic three-dimensional image or dataset may be constructed. Execution of the machine-executable instructions further causes the computational system to receive a stack-dependent orientation for the at least one stack of slices. The stack-dependent stack orientation may for example be a vector which is perpendicular to the plane of the slices that make up a particular stack of slices. If there are multiple stacks of slices then there would be, for example, a vector for possibly each stack of slices which is received.

Execution of the machine-executable instructions may cause the computational system to perform the following steps for slices or a slice of the at least one stack of slices. They may for example be performed for possibly each slice of the at least one stack of slices. These steps include determining a field of view for the slice using the volume of interest, the slice thickness, and the stack-dependent stack orientation. The slice may be compared to the volume of interest. The intersection of a particular slice in the volume of interest would be the field of view. The steps further comprise determining a readout direction for the slice and a phase encoding direction for the slice using the calibration data to optimize an image metric within the slice. The properties of a coil for a parallel imaging system may change depending upon the readout and phase encoding direction. The readout direction and phase encoding may therefore be chosen on a slice-by-slice basis to optimize the image metric.

The image metric may for example either be an image resolution or a signal-to-noise ratio. In some cases, it may be a different quantity which is for example proportional to or related to signal-to-noise. These steps also further comprise constructing slice-specific pulse sequence commands by modifying the initial pulse sequence commands using the field of view, the readout direction, and the phase encoding direction. In this step the initial pulse sequence commands are then adjusted using the field of view, the readout direction, and the phase encoding direction for possibly each individual slice. This enables the acquisition of the k-space data by a magnetic resonance imaging system for these individual slices. Examples may therefore provide for an improved means of acquiring multi-slice magnetic resonance images using a parallel imaging magnetic resonance imaging technique. Although multiple slices are acquired the readout and phase encoding directions are chosen for each slice by optimizing the image metric. This for example enables a constant signal to noise ratio, a minimal resolution, or optimized resolution for all slices. In particular, this facilitates using the individual slices to construct three-dimensional data sets.

In examples, the pulse sequence commands may use a given or fixed timing, say echo-train length (ETL), effective TE, etc. (Note: Strictly speaking the term ETL only applies to single-shot TSE/TFE imaging to maintain a constant image contrast or image weighting. The equivalent for FFE sequences is the number of phase-encoding steps which defines the acquisition time per slice.)

The phase-encoding direction and scan acceleration factor are determined by optimizing for the highest image resolution or other image metric that can be obtained for the given ETL.

For a given phase-encoding direction, the field of view may be determined as the bounding box of the intersection of the imaging plane (slice) with the object. In this step, the support of the object is used which can be determined from a sum-of-squares or a body-coil image taken from a SENSE (or other parallel imaging technique) reference scan.

Next, in some examples the maximal acceleration factor r along this phase-encoding direction may be determined. This can be done using several methods, but it may be based on a free parameter that serves as a threshold for what is deemed acceptable. I.e., it can be used to control the noise level of the reconstructed images and will most likely be application specific.

Now the achievable image resolution can be computed as Δp = FOV/(r*ETL). The phase-encoding direction is chosen such that this value is minimized.

A grid search could be a practical alternative to solving the optimization problem of the phase-encoding direction by inverse problems algorithms. E.g., by varying the phase-encoding direction in steps of 30°. Several methods of calculating the maximal acceleration factor are described below.

In another example the image metric is an image resolution. This example may be beneficial because it may provide a means for acquiring slices for the at least one stack of slices that have an image resolution above a predetermined threshold or the highest image resolution possible.

In one example, the image resolution is a signal-to-noise ratio for the slice and it is determined that it is above a predetermined minimum value. This for example may be beneficial in using the slices of the at least one stack of slices to construct three-dimensional datasets.

In another example, the so-called g-factor measure is optimized. This may be considered an indirect optimization for the signal-to-noise ratio.

In another embodiment, the image resolution is optimized using a maximal acceleration factor determined along the phase encoding direction.

In another example the image metric is a signal-to-noise ratio. Execution of the machine-executable instructions causes the computational system to optimize the signal-to-noise ratio for a fixed image resolution. This may be beneficial because the image resolution may be fixed and then so that the images are consistent with each other they have the signal-to-noise ratio optimized.

In another example the readout direction for the slice and the phase encoding direction for the slice is determined by repeatedly calculating the image metric for trial phase encoding directions or trial readout directions to optimize the image metric. In this example, various search or grid techniques may be used to choose an optimal or acceptable phase encoding direction or readout direction. This may be a numerically convenient or efficient way of determining the phase encoding direction or the readout direction.

In another example the calibration data is a set of coil sensitivity maps. For example, the calibration data may be a set of images and each of the images is acquired by various antenna elements from a multi-channel magnetic resonance imaging coil. Execution of the machine-executable instructions further causes the computational system to calculate a g-factor using the coil sensitivity maps for the trial phase encoding directions or the trial readout directions. Execution of the machine-executable instructions further causes the computational system to determine a maximal acceleration factor for the trial phase encoding directions or the trial readout directions using the g-factor for the different phase encoding directions. Execution of the machine-executable instructions further causes the computational system to calculate the image metric using the maximal acceleration factor. This embodiment may provide a numerically efficient way of determining the phase encoding direction or the readout direction for individual slices.

In this example one could maximize the acceleration factor such that the maximum of a SENSE g-factor map is below the acceptance threshold. In some cases, this can be a time-consuming computation. So for practical purposes, it can be simplified by e.g. considering only a fixed set of acceleration factors (1, 1.2, 1.4, ..., 3.8, 4), and computing the g-factor only on a subset of voxels of the imaging plane.

In another embodiment the g-factor is calculated using a subset of voxels within the slice. This may make the numerical calculation more rapid and efficient.

In another example the calibration data is a set of coil sensitivity maps. Execution of the machine-executable instructions further causes the computational system to calculate a maximal acceleration factor by calculating a singular value decomposition of the coil sensitivity maps along the phase encoding direction. Execution of the machine-executable instructions further causes the computational system to calculate the maximal acceleration factor by determining an effective rank by recording the index of singular values in the singular value decomposition for which a total signal power is reached. Execution of the machine-executable instructions further causes the computational system to calculate a maximal acceleration factor by setting a maximal acceleration factor using the effective rank. Execution of the machine-executable instructions further causes the computational system to calculate the image metric using the maximal acceleration factor.

In this example, from the (low-resolution) coil-sensitivity map (CSM = synergy / qbc) one may select lines along the acceleration direction and consider for possibly each line the matrix *X∈C^{(Np×Nc)},* where Np and Nc are the number of pixels and number of channels, respectively. The matrix *X is* decomposed for example SVD: *USV^{H}=X,* and the effective rank is determined by recording the index of the singular value sᵢ for which a certain amount of total signal power is reached, e.g. 95 or 99%. The lower the index, the smaller the acceleration capabilities of the coil array. Since these methods only rely on data of the SENSE reference scan and do not use information about the sequence timing. The computation of the maximal acceleration factor can be done independent and before the actual scan start.

In another example the calibration data is a set of coil sensitivity maps. The memory further stores a neural network configured for outputting the readout direction for the slice and the phase encoding direction for the slice in response to receiving the set of coil sensitivity maps and the field of view of the slice as input. Execution of the machine-executable instructions further causes the computational system to receive the readout direction for the slice and the phase encoding direction for the slice in response to inputting the preliminary magnetic resonance image and the field of view of the slice into the neural network. This embodiment may be beneficial because it may provide a very rapid means of choosing the readout direction and the phase encoding direction.

One architecture that may be used for the neural network is the Vision Transformer neural network architecture.

Another general neural network architecture that may be used is one which receives the coil sensitivity maps van processes them with a series of convolutional stages which passes this input through a flattening stage and to several fully connected layers. Additional information such as details about scan geometry or metadata descriptive of the subject may be passed directly to the fully connected layers.

The neural network may be trained by collecting the coil sensitivity maps and determining the readout direction and phase encoding direction using one of the numerical methods described above. The results of the numerical calculations can be stored and then used a training data.

In another example the calibration data is a lookup table that stores the readout direction for the slice and/or the phase encoding direction for the slice as a function of one or more properties of the field of view of the slice. Execution of the machine-executable instructions further causes the computational system to determine the readout direction for the slice and/or the phase encoding direction for the slice by comparing the one or more properties of the field of view of the slice to the lookup table. The field of view may for example be referenced in respect to the anatomical properties or landmarks of a particular individual for a particular magnetic resonance imaging coil. In various individuals basically the orientation of the readout direction or the phase encoding direction may not vary very much from subject-to-subject. In this case, instead of performing complicated numerical calculations or using a neural network storing the results of the numerical calculations and then averaging them over many different subjects may provide for a lookup table that can be used instead. This for example may have the advantage that it is extremely fast and eliminates the need for numerical calculations.

The lookup table may provide a practical alternative to a patient specific optimization of the PE direction and acceleration factor is to compute a look-up table which contains averages over a large number of values which were optimized patient-specifically.

This lookup table approach would not use the reformatted CSMs as input but more abstract, patient-independent data like used coil, anatomy, contrast, slice orientation...

The set of suitable input parameters can be determined by a clustering analysis of the output data. Again, instead of using a look-up table, machine learning techniques can be used to implement the mapping of these abstract categories to the output values (e.g. random forests).

In another example the slice-specific pulse sequence commands are configured to maintain a constant magnetic resonance imaging weighting. For example, various timings within the readout or the pulse spacing as well as the number of pulses may determine the type of weighting such as the T2, T1, or T2* weighting that a particular image has. The benefit of doing this is that the various slices will have the same contrast and may be more readily or more easily used to construct a three-dimensional dataset.

In another example the medical system further comprises a magnetic resonance imaging system. Execution of the machine-executable instructions further causes the computational system to repeatedly control the magnetic resonance imaging system with the slice-specific pulse sequence commands to acquire slice-specific k-space data. The slice-specific k-space data is the k-space data that is used to reconstruct the image for a particular slice. Execution of the machine-executable instructions further causes the computational system to reconstruct a slice-specific two-dimensional image using the slice-specific k-space data.

In another example execution of the machine-executable instructions further causes the computational system to assemble the slice-specific two-dimensional image for possibly each slice of the at least one stack of slices into a three-dimensional magnetic resonance image. This may be beneficial because it may provide a more uniform three-dimensional magnetic resonance image.

In another example the memory stores preliminary pulse sequence commands configured for acquiring preliminary k-space data. Execution of the machine-executable instructions further causes the computational system to control the magnetic resonance imaging system with the preliminary pulse sequence commands to acquire the preliminary k-space data. Execution of the machine-executable instructions further causes the computational system to reconstruct the calibration data from the preliminary k-space data. This for example may be beneficial because it may provide a means of calibrating the acquisition of the k-space data. The preliminary k-space data that is acquired may be part of a calibration sequence used to acquire the coil sensitivity maps for the parallel imaging magnetic resonance imaging protocol.

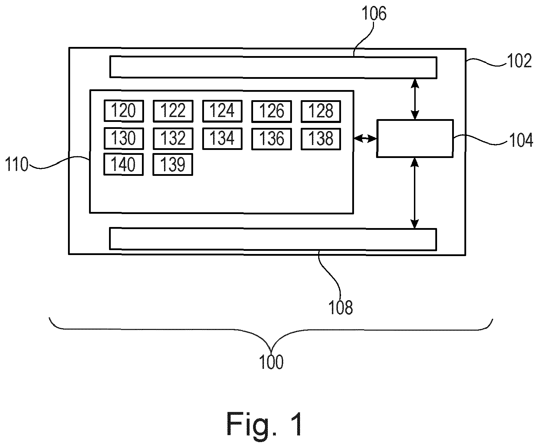

Fig. 1 illustrates an example of a medical system 100. The medical system 100 is shown as comprising a computer 102. The computer 102 is intended to represent one or more computers at one or more locations. The computer 102 is shown as comprising a computational system 104. The computational system 104 is intended to represent one or more computational systems or computing cores. The computational system 104 is shown as being in communication with an optional hardware interface 106. The hardware interface 106 may for example be used to communicate with and/or control other components of the medical system 100 if they are present or integrated into the medical system 100. The computational system 104 is further shown as being in communication with an optional user interface 108 that may enable a user or operator to control and operate the function of the medical system 100.

The computational system 104 is also shown as being in communication with a memory 110. The memory 110 is intended to represent various types of memory which may be accessible to the computational system 104. The memory 110 may for example be a non-transitory storage medium.

The memory 110 is shown as containing or storing machine-executable instructions 120. The machine-executable instructions 120 enable the computational system 104 to perform various tasks such as controlling other components, performing numerical calculations and manipulating data and/or images. The memory 110 is further shown as containing initial pulse sequence commands 122 that are configured to control a magnetic resonance imaging system to acquire k-space data according to a parallel imaging magnetic resonance imaging protocol. The initial pulse sequence commands 122 may for example be a template. The memory 110 is further shown as containing calibration data 124. The calibration data 124 may take different forms in different examples. In one example the calibration 124 may be coil sensitivity maps used for calibrating the magnetic resonance imaging system during the parallel imaging magnetic resonance imaging protocol. The calibration data 124 may also be a survey scan or an image reconstructed from images used to calibrate a multi element magnetic resonance imaging coil by providing the coil sensitivity maps.

The memory 110 is further shown as containing a volume of interest 126. In the case of the calibration data 124 is image data or coil sensitivity maps the volume of interest 126 may be specified in terms of its location within the calibration data 124. The memory 110 is further shown as containing a slice thickness 128 and a stack-dependent orientation 130 for a stack of slices which intersect with the volume of interest 128. The memory 110 is further shown as containing a field of view 132 for the slice that was obtained by intersecting or finding the intersecting volume between a particular slice and the volume of interest 126. The memory 110 is further shown as containing an optional numerical module 134. The optional numerical module 134 may for example be a module used to perform numerical calculations in some examples or it may be a neural network. If the numerical module perform a numerical calculation, then it may perform an optimization of an image metric 139. The memory 110 is further shown as containing a readout direction 136 and a phase encoding direction 138 that were obtained for a slice with the field of view 132, the slice thickness 128 and the stack-dependent orientation 130. This was performed using the calibration data 124. The memory 110 is further shown as containing a slice-specific pulse sequence commands 140 that were obtained by fitting or modifying the initial pulse sequence commands 122 using the field of view 132, the readout direction 136, and the phase encoding direction 138.

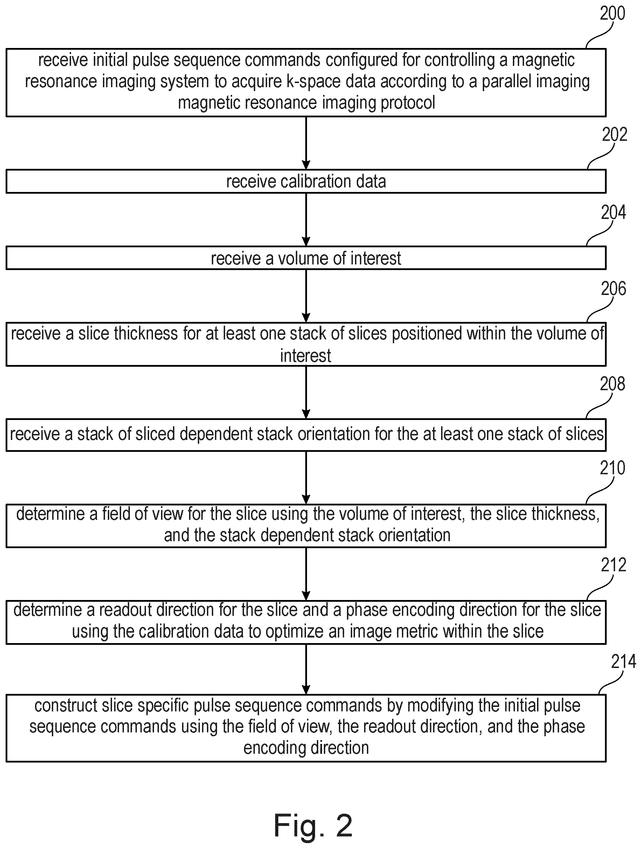

Fig. 2 shows a flowchart which illustrates a method of operating the medical system 100 of Fig. 1. In step 200 the initial pulse sequence commands 122 are received. The initial pulse sequence commands 122 are configured for controlling a magnetic resonance imaging system to acquire k-space data according to a parallel imaging magnetic resonance imaging protocol. In step 202 the calibration data 124 is received. In step 204 the volume of interest 126 is received. In step 206 the slice thickness 128 for at least one stack of slices positioned within the volume of interest is received. In step 208 a stack-dependent orientation 130 for the at least one stack of slices is received. The stack-dependent orientation 130 is different for possibly each of the at least one stack of slices. Steps 210, 212, and 214 may be repeated for possibly each slice of the at least one stack of slices. In step 210 the field of view of the slice 132 is determined using the volume of interest 126, the slice thickness 128 and the stack-dependent stack orientation 130. In step 212 the readout direction 136 and the phase encoding direction 138 are determined for the slice using the calibration data 124 to optimize an image metric 139 within the slice. In step 214 the slice-specific pulse sequence commands 140 are constructed by modifying the initial pulse sequence commands 122 using the field of view 132, the readout direction 136, and the phase encoding direction 138.

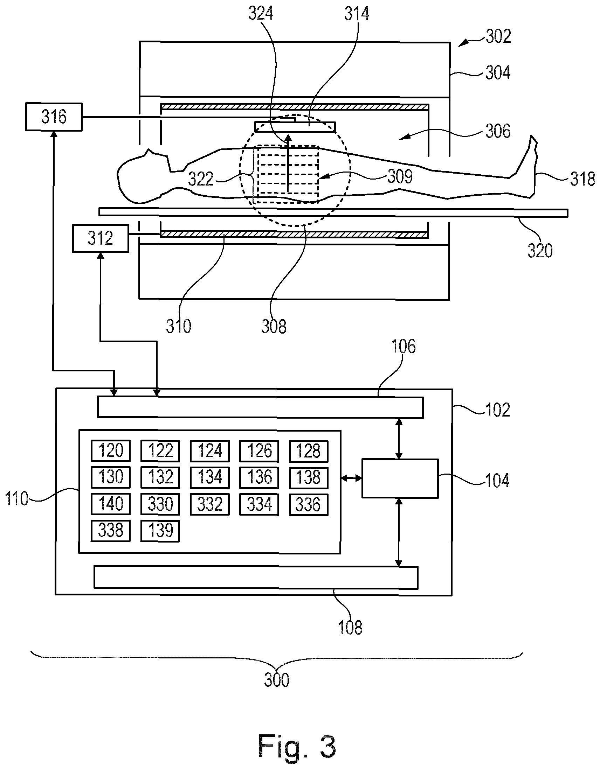

Fig. 3 illustrates a further example of a medical system 300. The medical system 300 is similar to the medical system 100 depicted in Fig. 1 except that it additionally comprises a magnetic resonance imaging system 302.

The magnetic resonance imaging system 302 comprises a magnet 304. The magnet 304 is a superconducting cylindrical type magnet with a bore 306 through it. The use of different types of magnets is also possible; for instance it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils.

Within the bore 306 of the cylindrical magnet 304 there is an imaging zone 308 where the magnetic field is strong and uniform enough to perform magnetic resonance imaging. A volume of interest 309 is shown within the imaging zone 308. Within the imaging zone 308 there is a stack of slices 322 positioned within the volume of interest 309. The stack of slices 322 are all perpendicular to a stack-dependent stack orientation 324. The k-space data that is acquired for a field of view indicated by one of the slices 322. A subject 318 is shown as being supported by a subject support 320 such that at least a portion of the subject 318 is within the imaging zone 308 and the volume of interest 309.

Within the bore 306 of the magnet there is also a set of magnetic field gradient coils 310 which is used for acquisition of preliminary k-space data to spatially encode magnetic spins within the imaging zone 308 of the magnet 304. The magnetic field gradient coils 310 connected to a magnetic field gradient coil power supply 312. The magnetic field gradient coils 310 are intended to be representative. Typically magnetic field gradient coils 310 contain three separate sets of coils for spatially encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308 is a radio-frequency coil 314 for manipulating the orientations of magnetic spins within the imaging zone 308 and for receiving radio transmissions from spins also within the imaging zone 308. The radio frequency antenna may contain multiple coil elements. The radio frequency antenna may also be referred to as a channel or antenna. The radio-frequency coil 314 is connected to a radio frequency transceiver 316. The radio-frequency coil 314 and radio frequency transceiver 316 may be replaced by separate transmit and receive coils and a separate transmitter and receiver. It is understood that the radio-frequency coil 314 and the radio frequency transceiver 316 are representative. The radio-frequency coil 314 is intended to also represent a dedicated transmit antenna and a dedicated receive antenna. Likewise the transceiver 316 may also represent a separate transmitter and receivers. The radio-frequency coil 314 may also have multiple receive/transmit elements and the radio frequency transceiver 316 may have multiple receive/transmit channels to perform the parallel imaging.

The transceiver 316 and the gradient controller 312 are shown as being connected to the hardware interface 106 of the computer system 102.

The memory 110 is further shown as containing preliminary pulse sequence commands 330. The memory 110 is further shown as containing preliminary k-space data 322 that was acquired by controlling the magnetic resonance imaging system 302 with the preliminary pulse sequence commands 330.

The memory 110 is further shown as containing slice-specific k-space data that was acquired by controlling the magnetic resonance imaging system with the slice-specific pulse sequence commands 140. The memory 110 is further shown as containing a slice-specific two-dimensional image 336 that was reconstructed from the slice-specific k-space data 334. The slice-specific two-dimensional image 336 may be reconstructed for each of the slices 322. The memory 110 is further shown as containing a three-dimensional magnetic resonance image 338 that was reconstructed by assembling the slice-specific two-dimensional image 336 for possibly each of the slices 322.

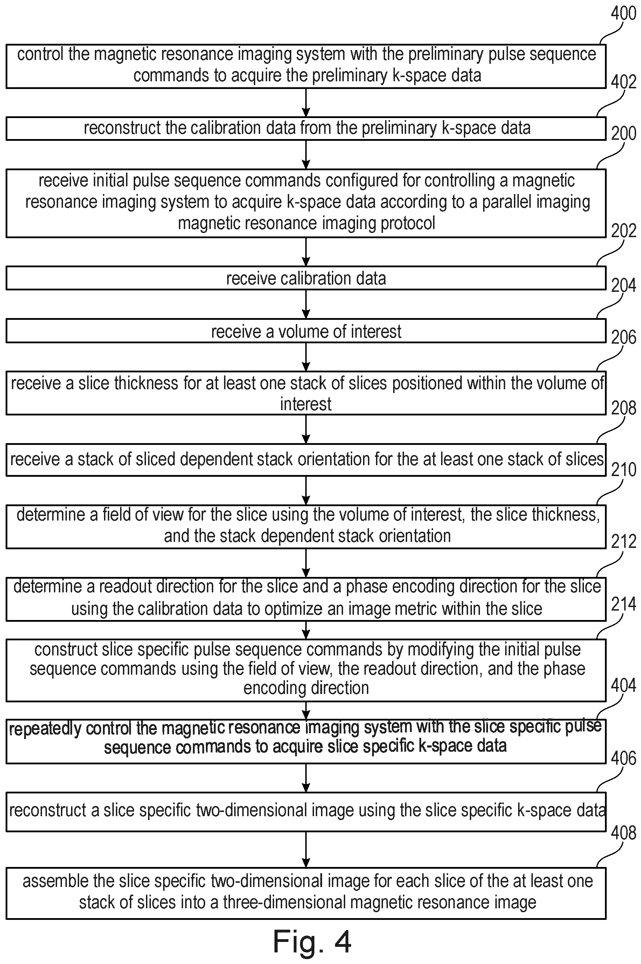

Fig. 4 shows a flowchart which illustrates a method of operating the medical system 300 of Fig. 3. In step 400 the magnetic resonance imaging system 302 is controlled with the preliminary pulse sequence commands 330 to acquire the preliminary k-space data 332. In step 402 the calibration data 124 is reconstructed or calculated from the preliminary k-space data 332. Steps 200, 202, 204, 206, 208, 210, 212, and 214 are performed as was illustrated in Fig. 2. Steps 404 and 406 may be performed for each slice 322. In step 404 the magnetic resonance imaging system 302 is controlled with the slice-specific pulse sequence commands 140 to acquire the slice-specific k-space data 334. In step 406 the slice-specific two-dimensional image 336 is reconstructed from the slice-specific k-space data 334. In step 408 the slice-specific two-dimensional image 336 from the various slices of the stack of slices 322 is assembled into the three-dimensional magnetic resonance image 338.

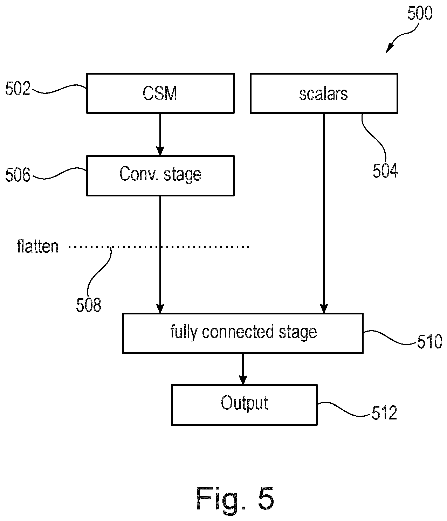

Figs. 5 through 9 below illustrate an implementation of a neural network that may be used to determine a readout direction and/or phase encoding direction for a slice. The generation of training data for the AI component (neural network) may be straightforward because input and output of the AI component are the same as for the slow iterative (numerical) optimization. I.e., for any input data the target output data can be computed by executing the conventional optimization. Since this is a slow computation, a data base containing pairs of input/target output data should be pre-computed prior to starting to train the AI component.

Fig. 5 illustrates an architecture of a neural network 500 that may be used to determine the readout direction 136 and/or the phase encoding direction 138. The input to the neural network 500 receives the coil sensitivity maps (CSM) 502 and various scalar values 504. The scalar values 504 may for example be used to input the field of view for the slice 132. The coil sensitivity maps 502 are processed by a number of convolutional layers 506 which then pass through a flattening later 508. The results of the flattening layer 508 and the scalar values 504 are passed to one or more fully connected layers 510. The fully connected layers 510 then provide the output 512 which may include the readout direction 136 and/or the phase encoding direction 138 for a particular slice.

There is a range of components that can be used to realize the neural network 500: Since the CSM part of the input data is a multi-channel 2D image it is beneficial to use convolutional blocks 506 to process these data. To reduce the number of variables, the convolutional blocks can interleaved with pooling layers.

The output of the convolutional stages is flattened 508 and combined with the scalar inputs (acceleration/number of PE steps) 504 and passed through one or more fully connected layers 510. Output of the fully connected layers 510 are either directly the two output parameters or a density for the two parameters, which is reduced by weighted averaging to the final output value. The latter case has the advantage that the training loss can be defined on the densities instead of the two scalar outputs, which gives stronger control over the gradients of the trainable parameters.

One practical problem is that the number of parameters of the fully connected layers is constant. This may requires that also the reformatted CSMs have a constant size. This can be achieved by zero-padding the CSMs of the actual imaging slice to a standard number of pixels which is large enough to cover all FOVs that are relevant for a given anatomy.

Also in the channel dimension the CSMs may preferably have a constant size. The most straightforward way to achieve this, is to train one network for each available MR coil. This also makes sense from an application perspective because different coils are typically also associated with different clinical questions and imaged anatomies, respectively. Training a separate network per receive coil should make the learning task significantly easier.

However, another way to achieve a constant number of channels would be to transform the CSMs of the physical channels to eigenmodes of the coil and then select a fixed number of the strongest eigenmodes.

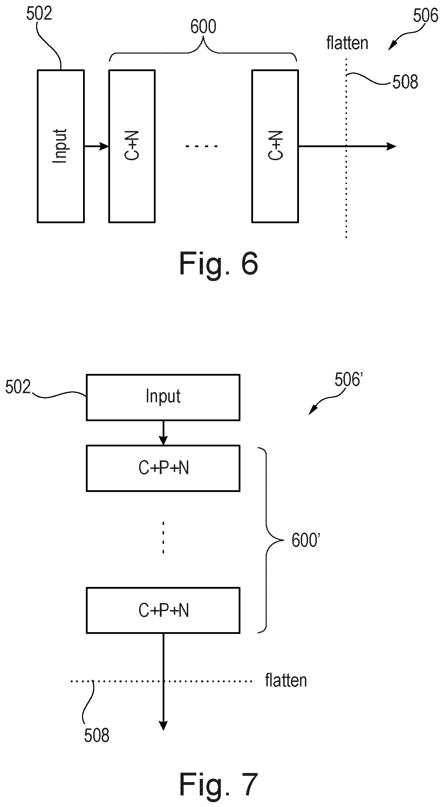

Fig. 6 illustrates the convolutional stage 506. The convolutional stage has an input 502 where the coil sensitivity maps are received and then it passes through a sequence of convolutions 600 that are a combination of convolutions and a non-linear operation. The output of these sequences of convolutions 600 is then passed to the flattening operation 508.

Fig. 7 illustrates an alternative to the convolutional input stage 506 illustrated in Fig. 6. In Fig. 7 there is an encoder input stage 506'. Again, it comprises a sequence of convolutions 600' however in this example it is a sequence which contains a convolution, a pooling operation and a non-linear operation. It may for example be equivalent to the descending half of a U-net neural network.

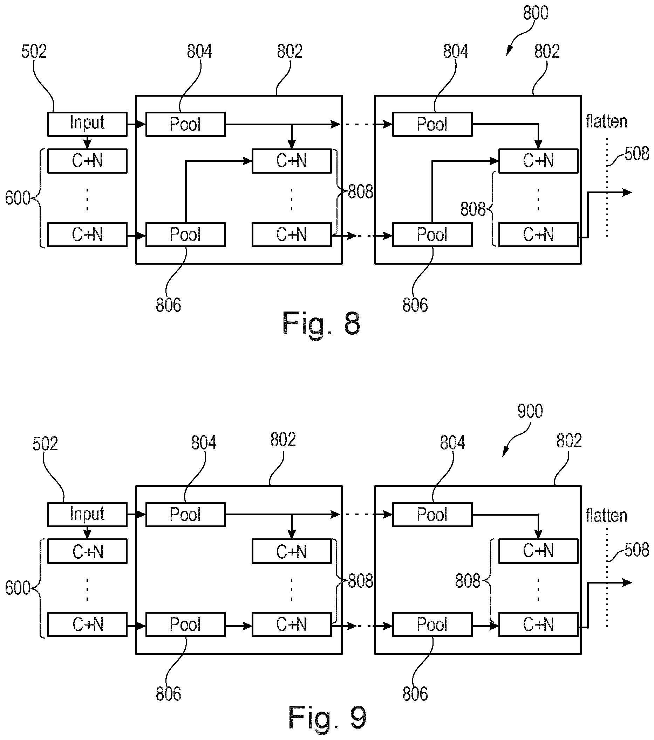

Fig. 8 illustrates a further alternative to the neural network. In this case a reversed multi-scale network 800 is illustrated. The input 502 is fed again to a sequence of convolutions 600 that comprise a convolutional operation and a non-linear operator. Both the input 502 and the result of the sequence of convolutions 600 is passed to a sequence of functional blocks 802. Within the blocks 802 there is a pooling layer 804 that receives the input 502 or the input from the previous block. A second pooling layer 806 receives the output of the sequence of convolutions 600 or the results of another sequence of convolutions 808 of the previous block. The results of the pooling layer from block 804 and 806 are fed to the input to another sequence of convolutions 808 that comprises a convolutional and a non-linear operator per layer. The blocks 802 may be repeated a number of times. The output of the final sequence of convolutions 808 is then input into the flattening layer 508.

Here, multiple volumes at decreasing spatial resolution are created from the input volume. These volumes are processed by a convolutional network. The output of the last convolutional stage of a higher spatial resolution is down-sampled and joined with the input of the following spatial scale. This architecture is similar to a multi-scale neural network except that the direction of joining the convolutional layers is reversed. In a multi-scale neural network, the final output has the same resolution as the input. Here, the final output has the same resolution as the lowest spatial scale.

Fig. 9 illustrates a further example of the input. The example in Fig. 9 is similar to the example in Fig. 8 except that it follows the architecture of a reversed F-net 900. The pooling layer 804 is again fed to the input of the sequence of convolutions 808 but the second pooling layer 806 is fed to the output or final layer of the sequence of convolutions 808. Here, the joining of the features happens at the output of the convolutional net. This is similar to an F-net, except that - as before -- the direction of joining the features is reversed.

There a several variations of the general architecture described above. E.g., the convolutional blocks can include a batch normalization layer, or they can be operated in residual mode. I.e., there are skip connections around convolutional blocks. Another variation is the choice of the pooling operation (max, mean, ...), the scale reduction factor, or the non-linear operation (ReLU, tanh, ...).

It is understood that one or more of the aforementioned examples or embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A `computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a computational system. `Computer storage' or 'storage' is a further example of a computer-readable storage medium. Computer storage is any non-volatile computer-readable storage medium. In some embodiments computer storage may also be computer memory or vice versa.

A `computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A `user interface' as used herein is an interface which allows a user or operator to interact with a computer or computer system. A `user interface' may also be referred to as a `human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A `hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or `display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

K-space data is defined herein as being the recorded measurements of radio frequency signals emitted by atomic spins using the antenna of a Magnetic resonance apparatus during a magnetic resonance imaging scan. Magnetic resonance data is an example of tomographic medical image data.

A Magnetic Resonance Imaging (MRI) image or MR image is defined herein as being the reconstructed two- or three-dimensional visualization of anatomic data contained within the magnetic resonance imaging data. This visualization can be performed using a computer.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

- 100: medical system
- 102: computer
- 104: computational system
- 106: hardware interface
- 108: user interface
- 110: memory
- 120: machine executable instructions
- 122: initial pulse sequence commands
- 124: calibration data
- 126: volume of interest
- 128: slice thickness
- 130: stack dependent stack orientation
- 132: field of view for slice
- 134: numerical module
- 136: readout direction
- 138: phase encoding direction
- 139: image metric
- 140: slice specific pulse sequence commands
- 200: receive initial pulse sequence commands configured for controlling a magnetic resonance imaging system to acquire k-space data according to a parallel imaging magnetic resonance imaging protocol
- 202: receive calibration data
- 204: receive a volume of interest
- 206: receive a slice thickness for at least one stack of slices positioned within the volume of interest
- 208: receive a stack of sliced dependent stack orientation for the at least one stack of slices
- 210: determine a field of view for the slice using the volume of interest, the slice thickness, and the stack orientation of the stack of slices
- 212: determine a readout direction for the slice and a phase encoding direction for the slice using the calibration data to optimize an image metric within the slice
- 214: construct slice specific pulse sequence commands by modifying the initial pulse sequence commands using the field of view, the readout direction, and the phase encoding direction
- 300: medical system
- 302: magnetic resonance imaging system
- 304: magnet
- 306: bore of magnet
- 308: imaging zone
- 309: volume of interest
- 310: magnetic field gradient coils
- 312: magnetic field gradient coil power supply
- 314: radio-frequency coil
- 316: transceiver
- 318: subject
- 320: subject support
- 322: stack of slices
- 324: stack dependent stack orientation
- 330: preliminary pulse sequence commands
- 332: preliminary k-space data
- 334: slice specific k-space data
- 336: slice specific two-dimensional image
- 338: three-dimensional magnetic resonance image
- 400: control the magnetic resonance imaging system with the preliminary pulse sequence commands to acquire the preliminary k-space data; and
- 402: reconstruct the calibration data from the preliminary k-space data
- 404: repeatedly control the magnetic resonance imaging system with the slice specific pulse sequence commands to acquire slice specific k-space data
- 406: reconstruct a slice specific two-dimensional image using the slice specific k-space data
- 408: assemble the slice specific two-dimensional image for the slices of the at least one stack of slices into a three-dimensional magnetic resonance image
- 500: neural network
- 502: coil sensitivity maps
- 504: scalar inputs
- 506: convolutional stage
- 506': convolutional stage
- 508: flattening layer
- 510: fully connected layers
- 512: output
- 600: sequence of convolutions
- 600': sequence of convolutions
- 800: reversed multi-scale network
- 802: block
- 804: first pooling layer
- 806: second pooling layer
- 808: sequence of convolutions
- 900: revered F-net network

## Claims

1. A medical system (100, 300) comprising:
- a memory (110) storing machine executable instructions (120);
- a computational system (104), wherein execution of the machine executable instructions causes the computational system to:
- receive (200) initial pulse sequence commands (122) configured for controlling a magnetic resonance imaging system (302) to acquire slice specific k-space data (334) according to a parallel imaging magnetic resonance imaging protocol;
- receive (202) calibration data (124);
- receive (204) a volume of interest (126);
- receive (206) a slice thickness (128) for at least one stack of slices (322) positioned within the volume of interest; and
- receive (208) a stack dependent stack orientation (130) for the at least one stack of slices;
wherein execution of the machine executable instructions causes the computational system to perform the following for slices of the at least one stack of slices:
- determine (210) a field of view (132) for a slice using the volume of interest, the slice thickness, and the stack orientation;
- determine (212) a readout direction (136) for the slice and a phase encoding direction (! 38) for the slice using the calibration data to optimize an image metric (139) within the slice; and
- construct (214) slice specific pulse sequence commands (140) by modifying the initial pulse sequence commands using the field of view, the readout direction, and the phase encoding direction.

2. The medical system of claim 1 or 2, wherein the image metric is an image resolution.

3. The medical system of claim 1, wherein the image metric is a signal to noise ratio, wherein execution of the machine executable instructions causes the computational system to optimize the signal to noise ratio for a fixed image resolution.

4. The medical system of claim 1, 2, or 3, wherein the readout direction for the slice and the phase encoding direction for the slice is determined by repeatedly calculating the image metric for trial phase encoding directions or trial readout directions to optimize the image metric.

5. The medical system of claim 4, wherein the calibration data is a set of coil sensitivity maps, wherein execution of the machine executable instructions further causes the computational system to:
- calculate a g-factor using the coil sensitivity maps for the trial phase encoding directions or trial readout directions, and
- determine a maximal acceleration factor for the trial phase encoding directions or the trial readout directions using the g-factor for the different phase encoding directions; and
- calculate the image metric using the maximal acceleration factor.

6. The medical system of claim 5, wherein the g-factor is calculated using a subset of voxels within the slice.

7. The medical system of claim 4, wherein the calibration data is a set of coil sensitivity maps, wherein execution of the machine executable instructions further causes the computational system to:
- calculate a singular value decomposition (SVD) of the coil sensitivity maps along the phase encoding direction;
- determine an effective rank by recoding an index of singular values in the singular value decomposition for which a total signal power is reached;
- set a maximal acceleration factor using the effective rank; and
- calculate the image metric using the maximal acceleration factor.

8. The medical system of claim 1, wherein the calibration data is a set of coil sensitivity maps, wherein the memory further stores a neural network configured for outputting the readout direction for the slice and the phase encoding direction for the slice in response to receiving the set of coil sensitivity maps and the field of view of the slice as input, wherein execution of the machine executable instructions further causes the computational system to receive the readout direction for the slice and the phase encoding direction for the slice in response to inputting the preliminary magnetic resonance image and the field of view of the slice into the neural network.

9. The medical system of claim 1, wherein the calibration data is a look up table storing the readout direction for the slice and/or the phase encoding direction for the slice for the slice as a function of one or more properties of the field of view of the slice, wherein execution of the machine executable instructions further causes the computational system to determine the readout direction for the slice and/or the phase encoding direction for the slice by comparing the one or more properties of the field of view of the slice to the lookup table.

10. The medical system of any one of the preceding claims, wherein the slice specific pulse sequence commands are configured to maintain a constant magnetic resonance imaging weighting.

11. The medical system of any one of the preceding claims, wherein the medical system further comprises a magnetic resonance imaging system, wherein execution of the machine executable instructions further causes the computational system to:
- repeatedly (404) control the magnetic resonance imaging system with the slice specific pulse sequence commands to acquire the slice specific k-space data; and
- reconstruct (406) a slice specific two-dimensional image using the slice specific k-space data.

12. The medical system of claim 11, wherein execution of the machine executable instructions further causes the computational system to assemble (408) the slice specific two-dimensional image for slices of the at least one stack of slices into a three-dimensional magnetic resonance image.

13. The medical system of claim 11 or 12, wherein the memory stores preliminary pulse sequence commands (330) configured for acquiring preliminary k-space data (332), wherein execution of the machine executable instructions further causes the computational system to:
- control (400) the magnetic resonance imaging system with the preliminary pulse sequence commands to acquire the preliminary k-space data; and
- reconstruct (402) the calibration data from the preliminary k-space data.

14. A computer program comprising machine executable instructions (120) for execution by a computational system (104), wherein execution of the machine executable instructions causes the computational system to:
- receive (200) initial pulse sequence commands (122) configured for controlling a magnetic resonance imaging system (302) to acquire slice specific k-space data (334) according to a parallel imaging magnetic resonance imaging protocol;
- receive (202) calibration data (124);
- receive (204) a volume of interest (126);
- receive (206) a slice thickness (128) for at least one stack of slices positioned within the volume of interest; and
- receive (208) a stack dependent stack orientation (130) for the at least one stack of slices; wherein execution of the machine executable instructions causes the computational system to perform the following for slices of the at least one stack of slices:
- determine (210) a field of view (132) for a slice using the volume of interest, the slice thickness, and the stack orientation of the stack of slices;
- determine (212) a readout direction (136) for the slice and a phase encoding direction for the slice using the calibration data to optimize an image metric within the slice; and
- construct (214) slice specific pulse sequence commands (140) by modifying the initial pulse sequence commands using the field of view, the readout direction, and the phase encoding direction.

15. A method of magnetic resonance imaging, wherein the method comprises:
- receiving (200) initial pulse sequence commands (122) configured for controlling a magnetic resonance imaging system (302) to acquire slice specific k-space data (334) according to a parallel imaging magnetic resonance imaging protocol;
- receiving (202) calibration data (124);
- receiving (204) a volume of interest (126);
- receiving (206) a slice thickness (128) for at least one stack of slices positioned within the volume of interest; and
- receiving (208) a stack dependent stack orientation (130) for the at least one stack of slices;
The method further comprises performing the following for slices of the at least one stack of slices:
- determining (210) a field of view (132) for a slice using the volume of interest, the slice thickness, and the stack orientation of the stack of slices;
- determining (212) a readout direction (136) for the slice and a phase encoding direction for the slice using the calibration data to optimize an image metric within the slice; and
- constructing (214) slice specific pulse sequence commands (140) by modifying the initial pulse sequence commands using the field of view, the readout direction, and the phase encoding direction.
